# EUROPEAN PATENT APPLICATION

(11) **EP 4 672 908 A1**
(43) Date of publication of application: **31.12.2025**
(21) Application number: 25174476.9
(22) Date of filing: 06.05.2025
(51) Int. Cl.: H10D 84/01, H10D 30/01, H10D 30/00, H10D 84/83

(54) **GATE-ALL-AROUND DEVICES WITH INNER SPACER AND CHANNEL THICKNESS MODULATION**

(30) Priority: 28.06.2024 US 202418758448
(71) Applicant: INTEL Corporation, Santa Clara, CA 95054 (US)
(72) Inventor: KOH, Shao Ming, Mountain View, 94041 (US); CHU, Tao, Portland, 97229 (US); GHOSTINE, Ramy, Portland, OR 97229 (US); LINDERT, Nick, Portland, OR 97229 (US); PAIK, Marvin, Portland, OR 97229 (US); TAN, Li Huey, Hillsboro, OR 97124 (US); THIRTHA, Vivek, Portland, 97229 (US); TIWARI, Vishal, HILLSBORO, OR 97123 (US)
(74) Representative: HGF

(57) **Abstract**

Techniques are provided to form semiconductor devices with different inner spacer widths and different nanoribbon (e.g., or nanowire, or nanosheet) thickness. In an example, any number of first semiconductor devices include first gate structures around first semiconductor regions and any number of second semiconductor devices include second gate structures around second semiconductor regions. First dielectric inner spacers are provided between the first gate structure and the corresponding source or drain regions of the first semiconductor devices with a first width and second dielectric inner spacers are provided between the second gate structure and the corresponding source or drain regions of the second semiconductor devices with a second width that is greater than the first width. In some such examples, the first semiconductor regions may be thinner compared to the second semiconductor regions to cause a corresponding increase in the threshold voltage of the first semiconductor devices.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Each device may not have the same purpose within the integrated circuit, and thus fabrication procedures that benefit the operation of one device may not benefit (or even be detrimental) to the other. Accordingly, there remain a number of non-trivial challenges with respect to forming such high-density semiconductor devices.

### BRIEF DESCRIPTION OF THE DRAWINGS

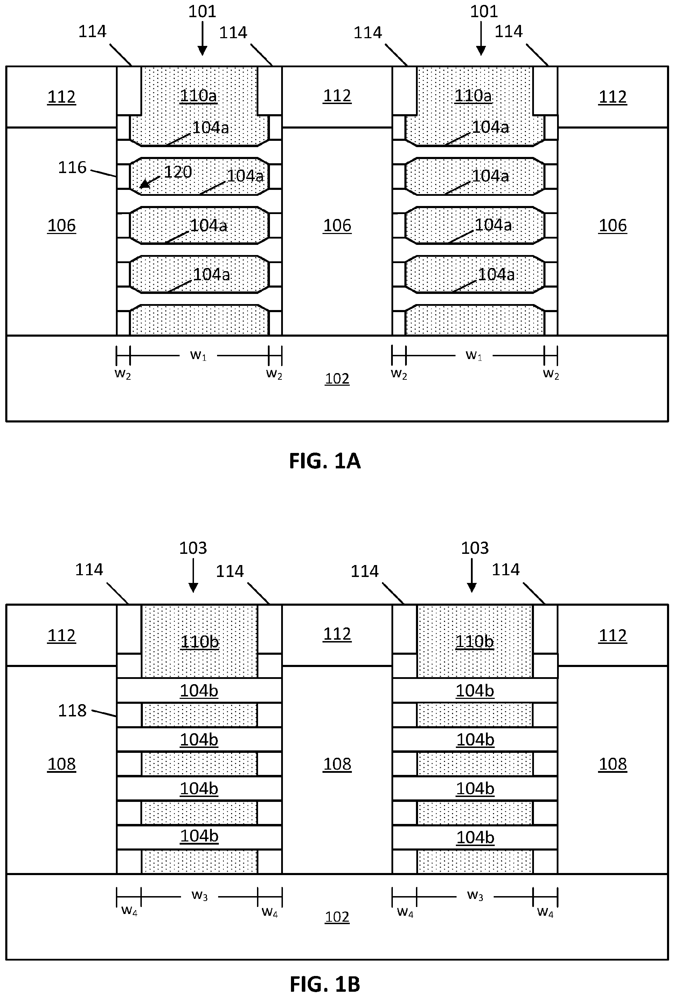

Figure 1A is a cross-sectional view of a pair of semiconductor devices having laterally thinned inner spacers and thinned nanoribbons, in accordance with an embodiment of the present disclosure.
Figure 1B is a cross-sectional view of another pair of semiconductor devices having wider inner spacers and thicker nanoribbons than the device in Figure 1A, in accordance with an embodiment of the present disclosure.

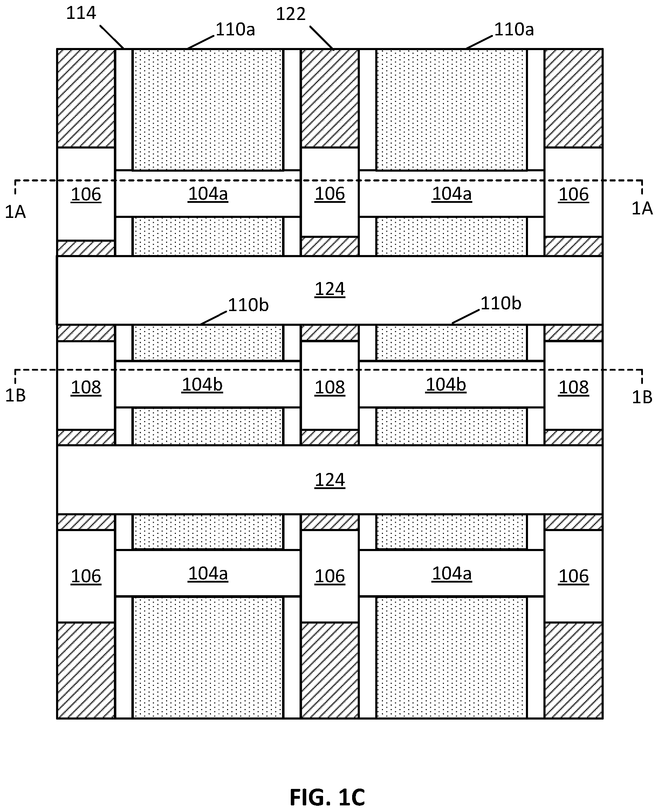

Figure 1C is a plan view of a portion of an integrated circuit that includes the pair of semiconductor devices from Figure 1A and the pair of semiconductor devices from Figure 1B.

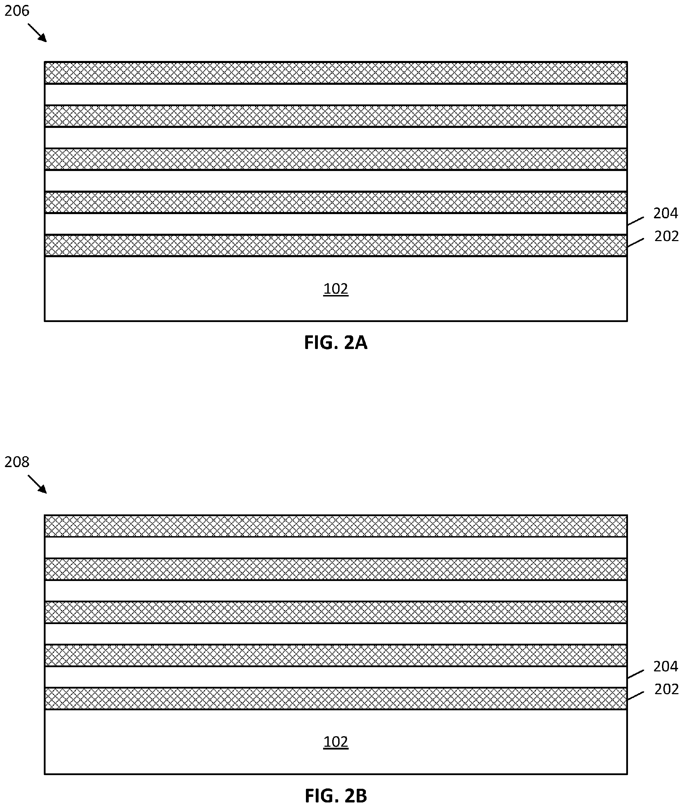

Figures 2A and 2B are cross-sectional views that illustrate one stage in an example process for forming an integrated circuit configured with one or more first devices having laterally thinner inner spacers and thinner nanoribbons compared to one or more second devices, in accordance with an embodiment of the present disclosure.

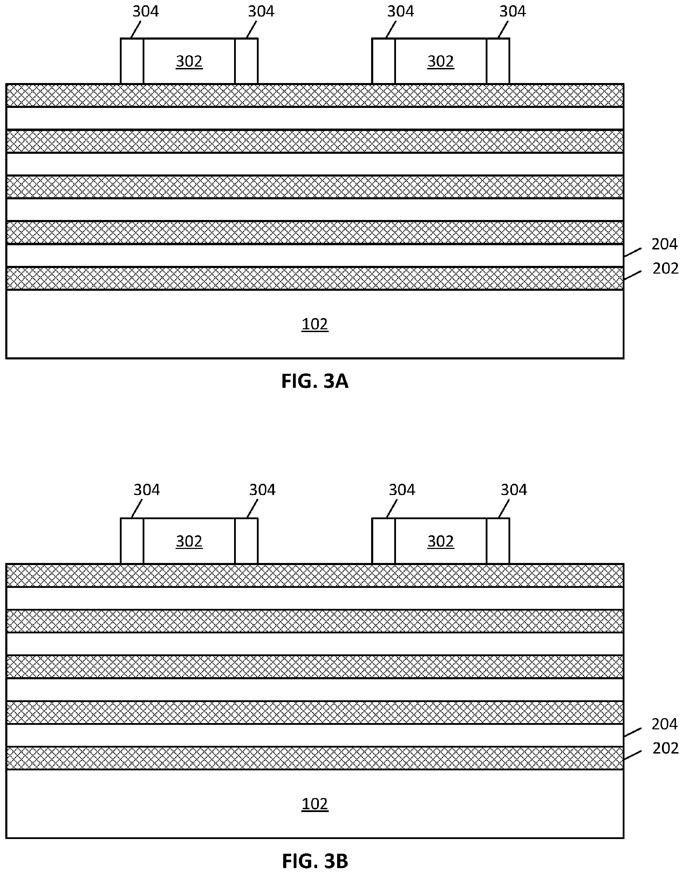

Figures 3A and 3B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

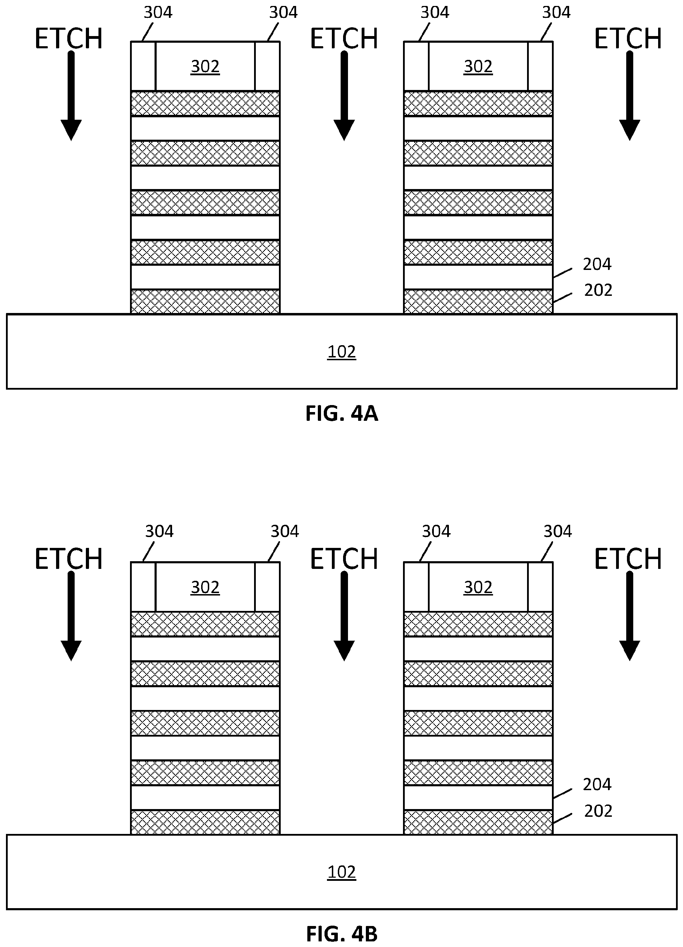

Figures 4A and 4B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

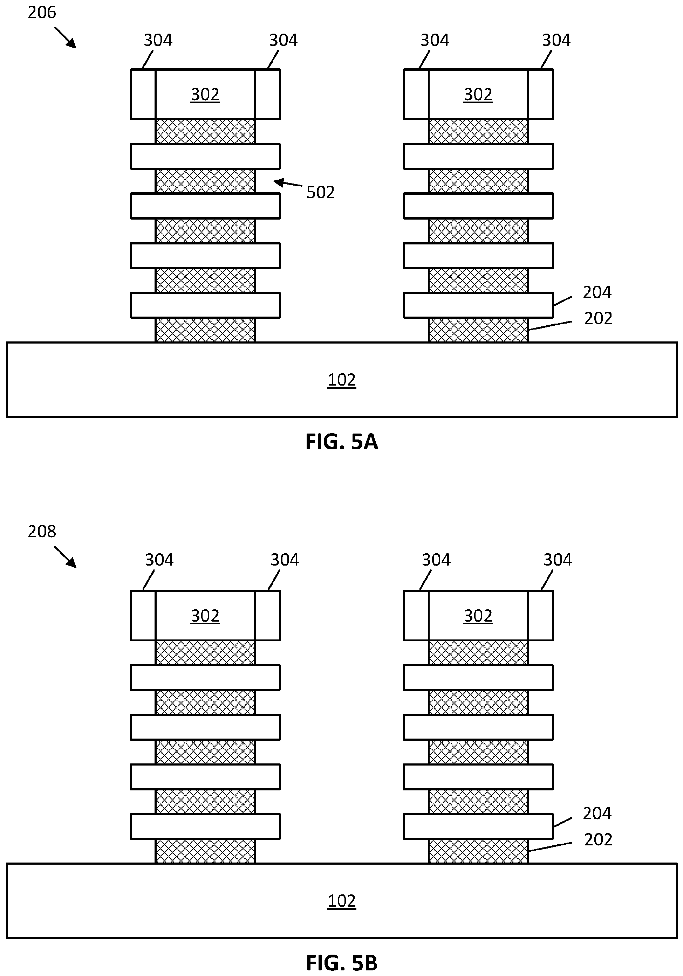

Figures 5A and 5B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

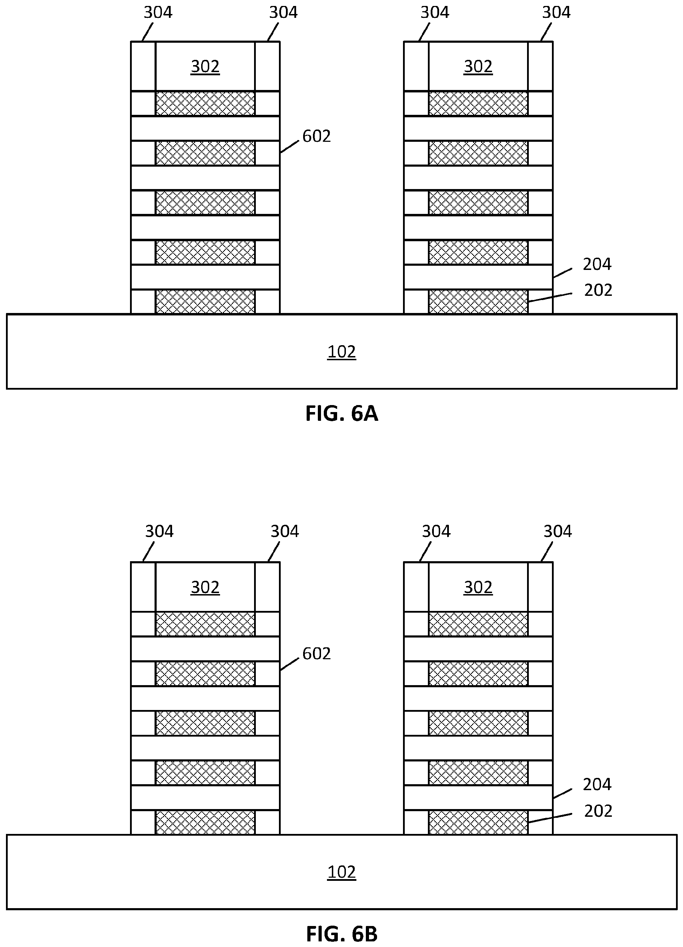

Figures 6A and 6B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

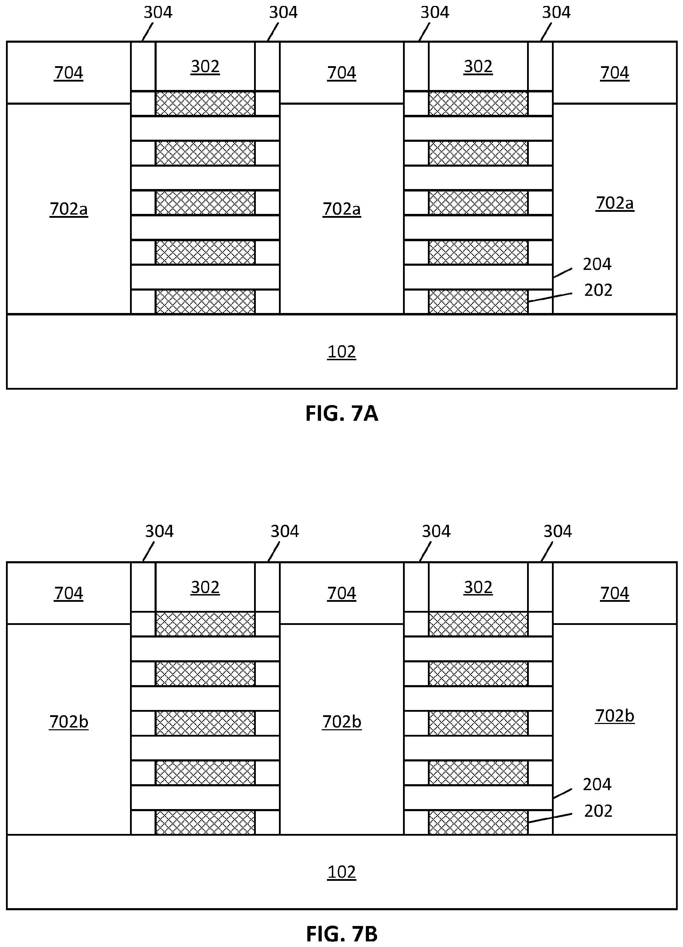

Figures 7A and 7B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

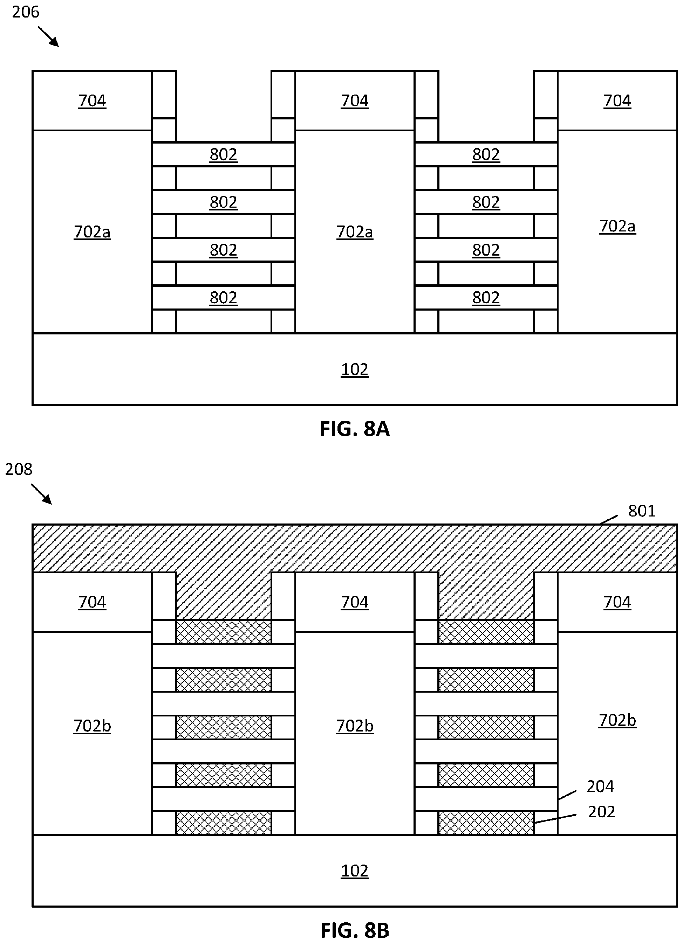

Figures 8A and 8B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

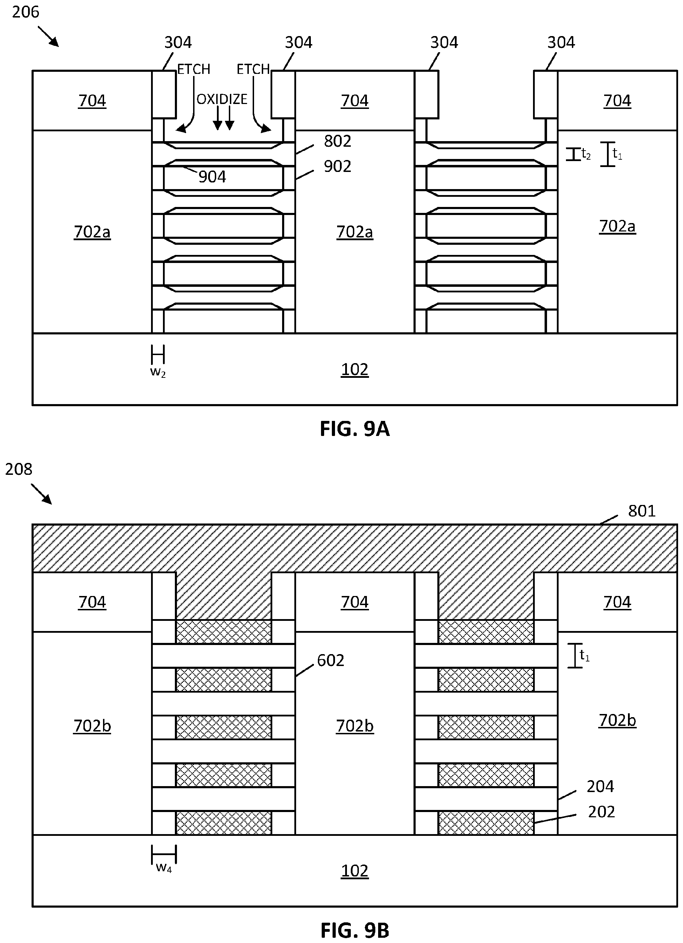

Figures 9A and 9B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

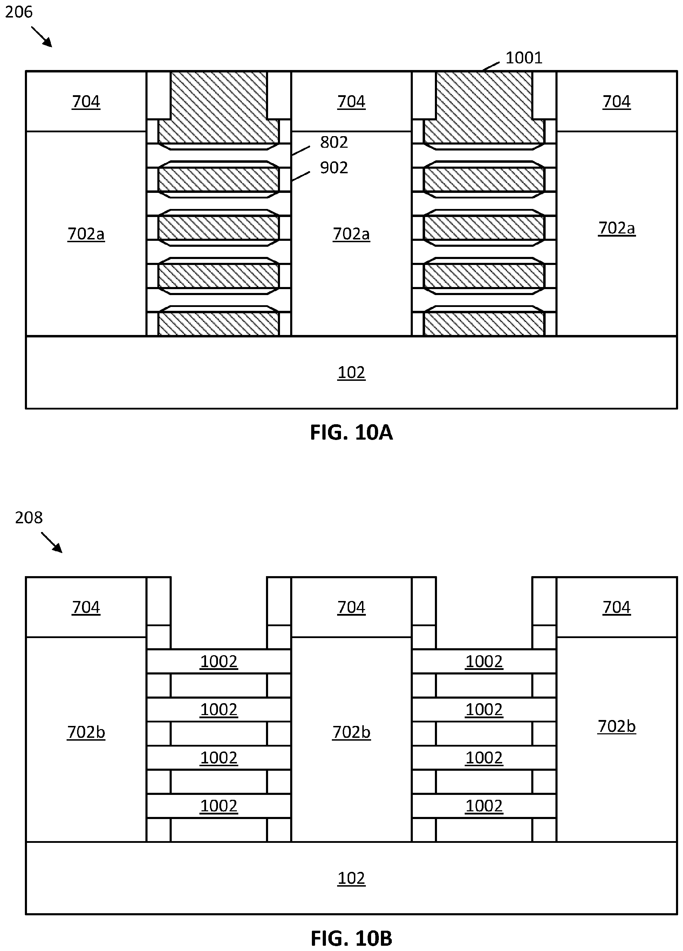

Figures 10A and 10B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

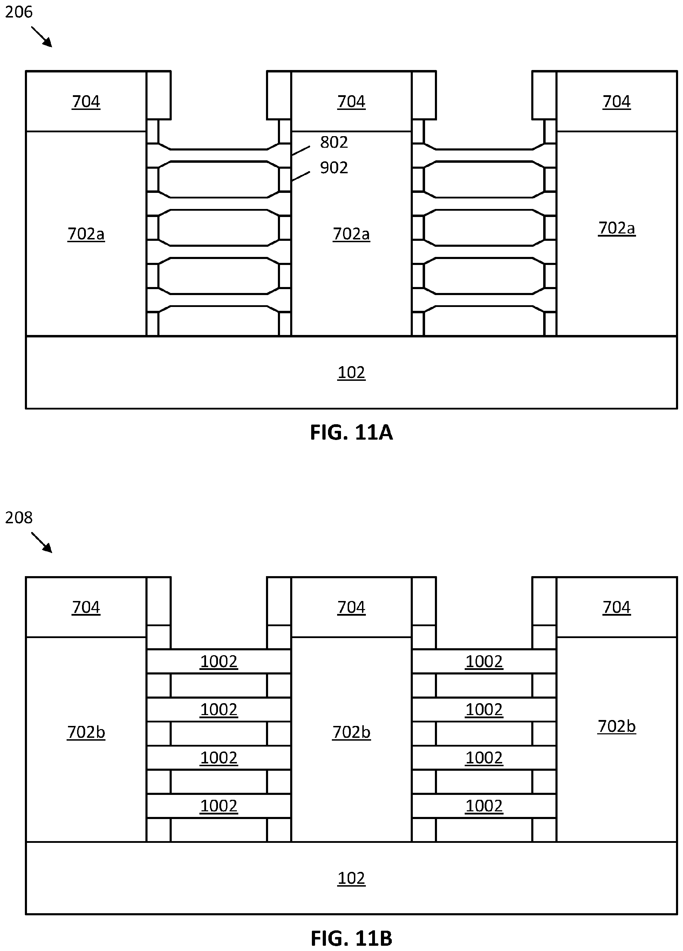

Figures 11A and 11B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

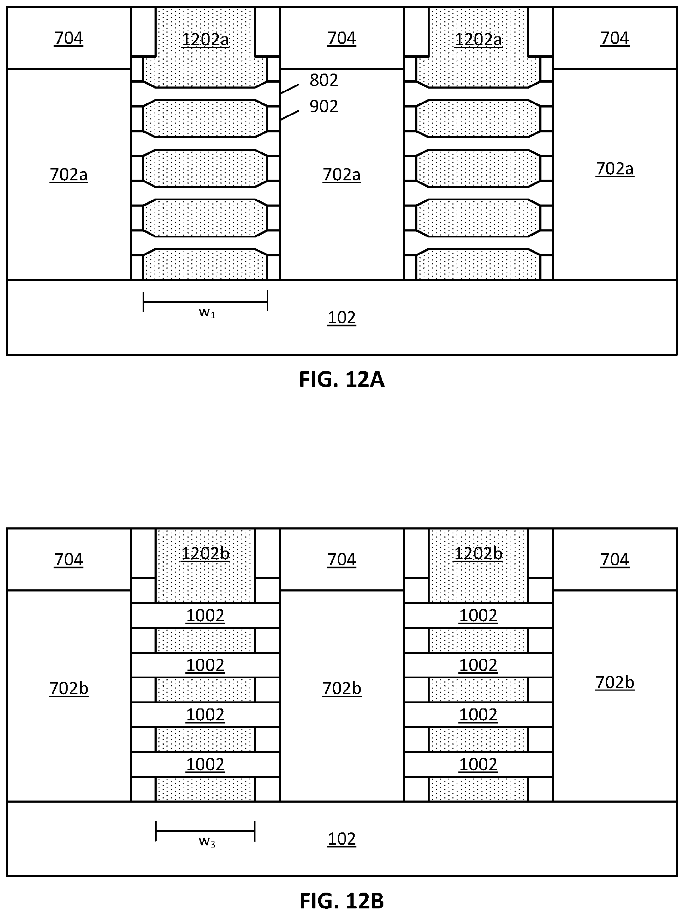

Figures 12A and 12B are cross-sectional views that illustrate another stage in the example process for forming an integrated circuit configured with one or more first devices having laterally thinner inner spacers and thinner nanoribbons compared to one or more second devices, in accordance with an embodiment of the present disclosure.

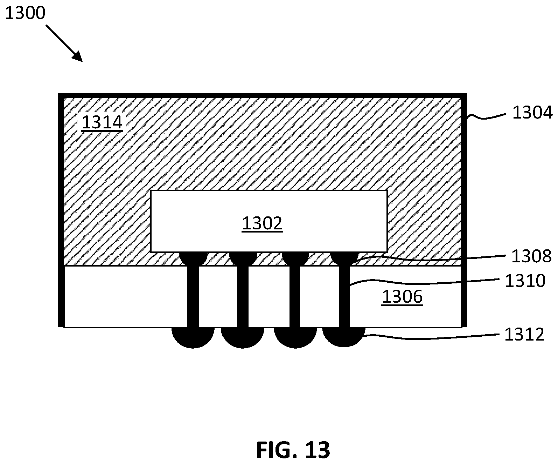

Figure 13 illustrates a cross-sectional view of a chip package containing one or more semiconductor dies, in accordance with some embodiments of the present disclosure.

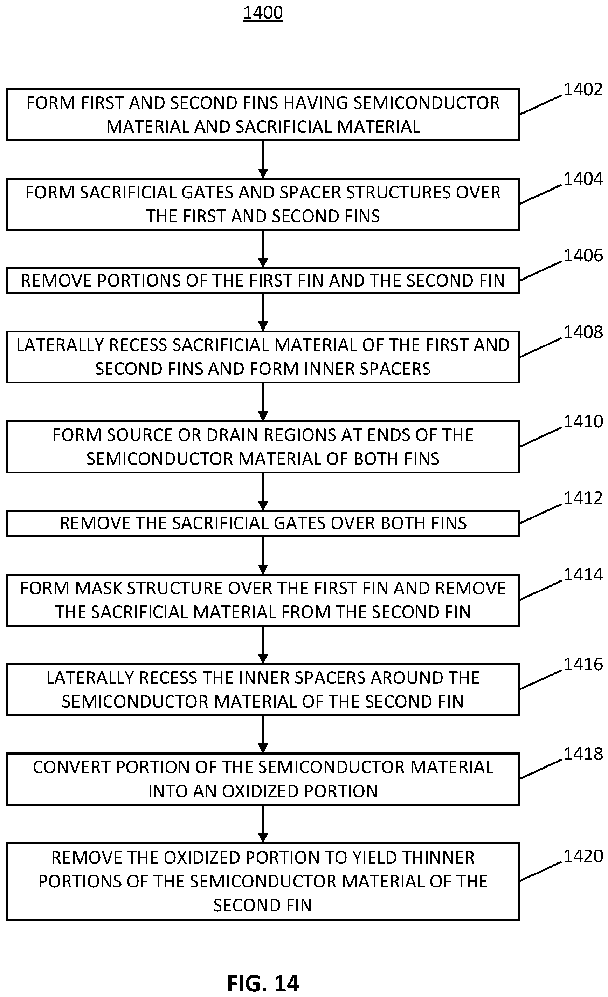

Figure 14 is a flowchart of a fabrication process for an integrated circuit having one or more first devices having laterally thinner inner spacers and thinner nanoribbons compared to one or more second devices, in accordance with an embodiment of the present disclosure.

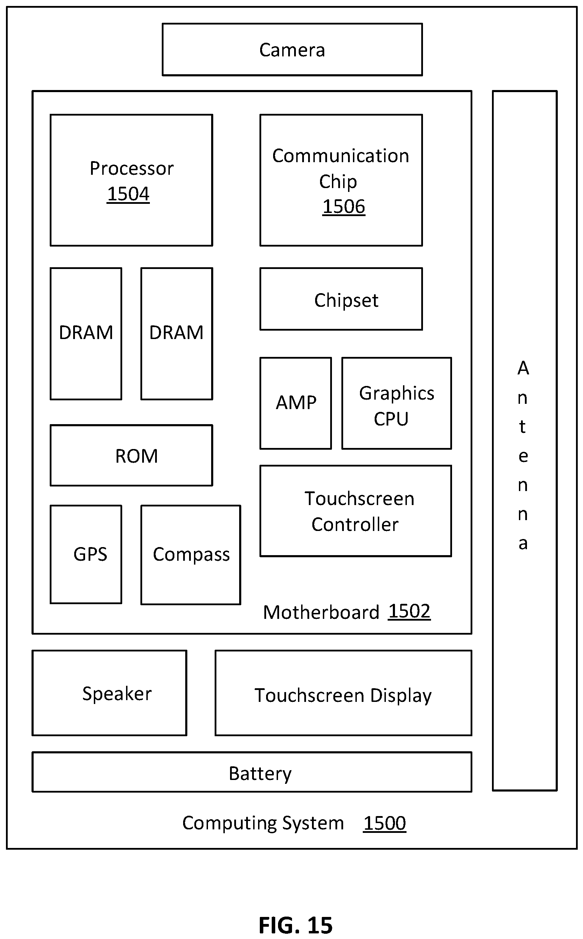

Figure 15 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices with different inner spacer widths and different nanoribbon thickness to cause changes in the threshold voltage. The techniques can be used in any number of integrated circuit applications and are particularly useful with respect to gate-all-around (GAA) transistors (e.g., ribbonFETs and nanowire FETs). In an example, any number of first semiconductor devices include first gate structures around first semiconductor regions and any number of second semiconductor devices include second gate structures around second semiconductor regions. The first and second semiconductor regions can be or one or more nanowires or nanoribbons or nanosheets of semiconductor material that extend between corresponding source and drain regions. The first and second gate structures include a gate dielectric and a gate electrode (e.g., conductive material such as workfunction material and/or gate fill metal) on the gate dielectric. According to some embodiments, first dielectric inner spacers are provided between the first gate structure and the corresponding source or drain regions of the first semiconductor devices with a first width, and second dielectric inner spacers are provided between the second gate structure and the corresponding source or drain regions of the second semiconductor devices with a second width that is greater than the first width. This difference in inner spacer width can be used to provide a corresponding difference in gate length between the first gate structure and the second gate structure, as further described below. Furthermore, the first semiconductor regions may be thinner compared to the second semiconductor regions to cause a corresponding increase in the threshold voltage of the first semiconductor devices. Numerous variations and embodiments will be apparent in light of this disclosure.

### General Overview

As previously noted above, there remain a number of non-trivial challenges with respect to integrated circuit fabrication. In more detail, gate-all-around (GAA) devices may be used for different tasks within a given integrated circuit. For example, some devices may require high switching speeds (e.g., high frequency devices) at the cost of higher power, while other devices may be designed to operate with low power consumption. This device criteria can be difficult to achieve across a given integrated circuit, as alterations to improve the performance of one type of device may have adverse effects for the other type of device. For example, high frequency devices show improved performance with lower threshold voltage, while devices having lower frequency and lower power show improved performance with higher threshold voltage to reduce leakage. In other examples, memory applications (e.g., static random access memory) may benefit from transistors with lower leakage and higher threshold voltage, while other applications like logic circuits may benefit from transistors with lower threshold voltage to facilitate high-speed operation.

Thus, and in accordance with an embodiment of the present disclosure, techniques are provided herein to form GAA semiconductor devices with different inner spacer widths and different nanoribbon thickness to cause threshold voltage and/or current leakage variation between the devices. As used herein, the width of the inner spacer refers to its lateral dimension along the length of the nanoribbons (e.g., a first direction) and may also be referred to as the lateral thickness of the inner spacer. According to an embodiment, the threshold voltage is increased in one or more first GAA devices compared to one or more second GAA devices by increasing the gate length (Lg), and thinning the nanoribbon thickness of the one or more first GAA devices. These structural changes may also result in a lower current leakage in the one or more first GAA devices compared to the one or more second GAA devices.

According to some embodiments, the Lg of the one or more first GAA devices is increased by reducing the width of the inner spacers that separate the gate structure from the source or drain regions of the transistor. In some such examples, an isotropic dielectric etching process is performed to laterally etch back the inner spacers from within the gate trench following the removal of a sacrificial gate and releasing of nanoribbons within the gate trench. The width of the inner spacers may be decreased, for instance, by at least 1 nm, at least 2 nm, or at least 3 nm. Other examples may be configured differently.

According to some embodiments, the threshold voltage of the one or more first GAA devices may be increased by reducing the thickness of the nanoribbons along their length (e.g., reducing the thickness of the nanoribbons within the gate trench between the spacer structures). The channel resistance is increased by reducing the cross-sectional area of the nanoribbons (e.g., thinning the exposed portions of the nanoribbons within the gate trench). The nanoribbons may be effectively thinned during the same procedure that laterally etches the inner spacers, as will be discussed in more detail herein. According to some embodiments, the nanoribbons of the one or more first GAA devices may be thinned to a final thickness, for instance, between about 3 nm and about 5 nm. In some examples, the nanoribbons of the one or more first GAA devices are at least 2 nm, at least 3 nm, at least 4 nm, or at least 5 nm thinner than the nanoribbons of the one or more second GAA devices. Other examples may be configured differently.

According to an embodiment, an integrated circuit includes a first semiconductor device having at least one first semiconductor body extending in a first direction from a first source or drain region, a first gate structure extending in a second direction over the first semiconductor body and over the at least one first semiconductor body, and at least one first dielectric spacer between the first gate structure and the first source or drain region along the first direction. The integrated circuit also includes a second semiconductor device having at least one second semiconductor body extending in the first direction from a second source or drain region, a second gate structure extending in the second direction over the at least one second semiconductor body and over the at least one second semiconductor body, and at least one second dielectric spacer between the second gate structure and the second source or drain region along the first direction. In some such examples, the at least one first dielectric spacer is at least 1 or 2 nm wider than the at least one second dielectric spacer, along the first direction. The at least one first semiconductor body has a first thickness, for instance, that is at least 2 or 3 nm greater than a second thickness of the at least one second semiconductor body.

According to another embodiment, an integrated circuit includes a semiconductor device having at least one semiconductor nanoribbon that extends in a first direction from a source or drain region and a gate structure extending in a second direction over the at least one semiconductor nanoribbon, a dielectric gate spacer on a sidewall of a top portion of the gate structure, and a dielectric inner spacer below the dielectric gate spacer and between the gate structure and the source or drain region along the first direction. The gate structure has a first length laterally adjacent to the dielectric gate spacer along the first direction and a second length laterally adjacent to the dielectric inner spacer along the first direction with the second length being, for instance, at least 2 nm greater than the first length. The at least one semiconductor nanoribbon has a first section contacting the gate structure with a first thickness and a second section contacting the source or drain region with a second thickness with the second thickness being, for instance, at least 2 or 3 nm greater than the first thickness.

According to another embodiment, a method of forming an integrated circuit includes: forming a first fin comprising first semiconductor layers alternating with first sacrificial layers, the first fin extending above a substrate and extending in a first direction; forming a second fin comprising second semiconductor layers alternating with second sacrificial layers, the second fin extending above a substrate and extending in the first direction; forming a first sacrificial gate and first spacer structures over the first fin and a second sacrificial gate and second spacer structures over the second fin; removing exposed portions of the first fin and the second fin not protected by the first sacrificial gate and first spacer structures and the second sacrificial gate and second spacer structures; laterally recessing the first sacrificial layers to form first laterally recessed areas and the second sacrificial layers to form second laterally recessed areas; forming first inner spacers within the first laterally recessed areas and second inner spacers within the second laterally recessed areas; forming a first source or drain region from exposed ends of the first semiconductor layers and a second source or drain region from exposed ends of the second semiconductor layers; removing the first and second sacrificial gates; forming a mask structure over the first fin; removing the second sacrificial layers of the second fin; performing a lateral etch of the second inner spacers around the second semiconductor layers; converting a portion of the second semiconductor layers into an oxidized portion; and removing the oxidized portion to yield thinner sections of the second semiconductor layers..

The techniques can be used with any type of non-planar transistors, but are especially useful for nanowire and nanoribbon transistors (sometimes called GAA transistors), as well as nanosheet transistors (sometimes called forksheet transistors), to name a few examples. The source and drain regions can be, for example epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate one or more GAA devices having narrower inner spacer structures (e.g., at least 1 nm thinner along the first direction) compared to other GAA devices. In some examples, the GAA devices having the narrower inner spacer structures also have thinner nanoribbons (e.g., at least 2 nm thinner) within the gate trench (e.g., contacting the gate structure) compared to the other GAA devices. Such features may also be observed in fork sheet transistors.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "backside" generally refers to the area beneath one or more semiconductor devices (below the device layer) either within the device substrate or in the region of the device substrate (in the case where the bulk of the device substrate has been removed). Note that the backside may become a frontside, and vice-versa, if a given structure is flipped. To this end, and as will be appreciated, the use of terms like "above" "below" "beneath" "upper" "lower" "top" and "bottom" are used to facilitate discussion and are not intended to implicate a rigid structure or fixed orientation; rather such terms merely indicate spatial relationships when the structure is in a given orientation.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

Figure 1A is a cross-sectional view taken across a pair of first semiconductor devices 101 and Figure 1B is a cross-sectional view taken across a pair of second semiconductor devices 103, according to an embodiment of the present disclosure. Second semiconductor devices 103 may be further along the same fin as first semiconductor devices 101, or may be part of a different fin extending parallel to the fin of first semiconductor devices 101. Each of the semiconductor devices may be, for instance, non-planar metal oxide semiconductor (MOS) transistors, such gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Other examples may have a forksheet structure having a p-type device and an n-type device separated by a dielectric spine or structure. First and second semiconductor devices 101 and 103 together represent a portion of an integrated circuit that may contain any number of similar semiconductor devices. First and second semiconductor devices 101 and 103 could exist anywhere within the integrated circuit (on the same die).

As can be seen, semiconductor devices 101 and 103 are formed on a same substrate 102 (or die). Any number of other semiconductor devices can be formed on substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 102 is removed from the backside and replaced with one or more dielectric layers along with conductive layers to form backside contacts and backside interconnect layers, such as a power delivery network.

First semiconductor devices 101 may include any number of semiconductor nanoribbons 104a while second semiconductor devices 103 similarly may include any number of semiconductor nanoribbons 104b. Nanoribbons 104a may extend between source or drain regions 106 along a first direction (e.g., across the page). Likewise, nanoribbons 104b may extend between source or drain regions 108 along the first direction. Any source region may also act as a drain region and vice versa, depending on the application. Nanoribbons 104a and 104b can also be nanowires or nanosheets or other such semiconductor bodies and may have any number of geometries, such as circular, square, rectangular, or pancake-like (rectangular shape that is elongated into and out of page and relatively short up and down the page).

In some embodiments, semiconductor devices 101 and 103 have an equal number of nanoribbons, while in other embodiments they have an unequal number of nanoribbons. For instance, the example shown includes four nanoribbons in each channel region, but other examples may include one, two or three nanoribbons (or other semiconductor bodies). In some embodiments, each of nanoribbons 104a and nanoribbons 104b are formed from a fin of alternating material layers (e.g., alternating layers of silicon and silicon germanium) where sacrificial material layers are removed between nanoribbons 104a and nanoribbons 104b. In other embodiments, each of nanoribbons 104a and nanoribbons 104b may include the same semiconductor material as substrate 102, or another material layered on top of substrate 102. In still other cases, substrate 102 is removed. In some such example cases, there may be, for example one or more backside interconnect and/or contact layers.

According to some embodiments, source or drain regions 106/108 are epitaxial regions that are provided using an etch-and-replace process. Any semiconductor materials suitable for source and drain regions can be used (e.g., group IV and group III-V semiconductor materials). The source or drain regions may include multiple layers such as liners and capping layers to improve contact resistance and/or adhesion. In any such cases, the composition and doping of the source or drain regions 106/108 may be the same or different, depending on factors such as the polarity of the transistors and the given circuit application. Any number of source and drain configurations and materials can be used. Source or drain regions 106/108 may represent n-type source or drain regions (e.g., silicon doped with phosphorous) or may represent p-type source or drain regions (e.g., silicon germanium doped with boron.

According to some embodiments, the fin structures include alternating layers of material (e.g., alternating layers of silicon and silicon germanium (SiGe)) that facilitates forming of nanoribbons (or nanowires or nanosheets, as the case may be) during a gate forming process where one type of the alternating layers is selectively etched away so as to liberate the other type of alternating layers within the channel region, so that a gate-all-around (GAA) process flow can then be carried out. In other examples, a forksheet process flow may be used, and the techniques described herein can also be beneficially applied to that process flow to provide gate length diversity, as further described below. The alternating layers can be blanket deposited and then etched into fin structures or deposited into fin-shaped trenches.

According to some embodiments, a first gate structure 110a extends along a second direction into and out of the page over nanoribbons 104a of first semiconductor devices 101. Similarly, a second gate structure 110b extends along the second direction over nanoribbons 104b of second semiconductor devices 103. The second direction may be substantially orthogonal (e.g., 90 degrees, plus or minus a degree or two) to the first direction. According to some embodiments, each of the first and second gate structures 110a/110b includes a gate dielectric and a gate electrode. The gate dielectric may include any suitable dielectric material such as silicon dioxide and/or hafnium oxide. In some examples, the gate dielectric includes high-k material having a dielectric constant greater than 6.5. Some example high-k materials include hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

According to some embodiments, the gate electrodes of first and second gate structures 110a/110b may include any sufficiently conductive material such as a metal or metal alloy (e.g., tungsten or tungsten nitride), or polysilicon. In some embodiments, the gate electrodes include one or more work function metals on the gate dielectric and around the corresponding nanoribbons. For example, a p-channel device may include a work function metal having titanium on the gate dielectric and around the nanoribbons of the p-channel device. In another example, an n-channel device may include a work function metal having tungsten on the gate dielectric and around nanoribbons of the n-channel device. In some embodiments, the gate electrodes each includes a fill metal or other conductive material on the work function metal(s) to provide the whole gate electrode structure.

A conductive contact 112 may be formed over any of source or drain regions 106/108 to provide electrical connections to the corresponding source or drain regions. Conductive contact 112 can include any suitable conductive material, such as tungsten, copper, cobalt, titanium, ruthenium, tantalum, or molybdenum, or alloys of any of these. Contacts 112 may also include multiple layers, such as barrier and/or liner layers to inhibit electromigration and/or improve adhesion and contact resistance (e.g., layer of tantalum, titanium, or nitrides of same). In some examples, contacts 112 are formed through a dielectric fill that is present over source or drain regions 106/108.

According to some embodiments, spacer structures 114 are present on sidewalls of gate structures 110a/110b to separate the gate structures from the source/drain trenches. Accordingly, spacer structures 114 extend along the second direction with gate structures 110a/110b. Spacer structures 114 may include any suitable dielectric material, such as silicon nitride or silicon oxynitride, and may include multiple layers such as a first layer of silicon nitride and a second layer of silicon dioxide on the layer of silicon nitride.

As further shown in the example case of Figures 1A and 1B, semiconductor devices 101 include first inner spacers 116 around the ends of nanoribbons 104a, and second semiconductor devices 103 include second inner spacers 118 around the ends of nanoribbons 104b. First and second inner spacers 116/118 may include the same dielectric material as gate spacer structures 114 or may include any other suitable dielectric material. According to some embodiments, the lateral dimension of first and second inner spacers 116/118 along the first direction directly affects the gate length of the transistors. The gate length corresponds to the length of semiconductor material extending from a source region to a drain region and that is covered (wrapped) by the gate structure. For example, first semiconductor devices 101 have a gate length w₁ (which corresponds to the length of first gate structure 110a around nanoribbons 104a, in this example), with a first inner spacer width w₂, and second semiconductor devices 103 have a gate length w₃ (which corresponds to the length of second gate structure 110b around nanoribbons 104b, in this example), with a second inner spacer width w₄. According to some embodiments, first semiconductor devices 101 have a larger gate length w₁ compared to the gate length w₃ of second semiconductor devices 103 because first inner spacers 116 have a smaller width w₂ compared to the width w₄ of second inner spacers 118. For example, the width w₂ of first inner spacer 116 may be purposefully at least 1 nm, at least 2 nm, or at least 3 nm smaller than the width w₄ of second inner spacer 118. Similarly, the gate length w₁ of first gate structure 110a may be purposefully at least 2 nm, at least 3 nm, at least 4 nm, or at least 5 nm greater than the gate length w₃ of second gate structure 110b. According to some embodiments, the gate length w₁ of first gate structure 110a may be between about 15 nm and about 23 nm, such as between about 18 nm and about 19 nm, and the gate length w₃ of second gate structure 110b may be between about 11 nm and 19 nm, such as between 14 nm and 15 nm. The width w₂ of first inner spacers 116 may be, for instance, between about 3 nm and about 5 nm, and the width w₄ of second inner spacers 118 may be, for instance, between about 5 nm and about 7 nm.

According to some embodiments, nanoribbons 104a of first semiconductor devices 101 are thinner compared to nanoribbons 104b of second semiconductor devices 103. In some examples, nanoribbons 104a are at least 2 nm, at least 3 nm, at least 4 nm, or at least 5 nm thinner compared to nanoribbons 104b. Nanoribbons 104a may be thinned within the gate trench (e.g., the portion that contacts first gate structure 110a). As such, other portions of nanoribbons 104a between first inner spacers 116 may have the original thickness and are not thinned. According to some embodiments, the thickness of nanoribbons 104a changes across a transition region 120 at the edges of the gate trench from a first thickness adjacent to source or drain region 106 to a second minimum thickness within the gate trench (e.g., at roughly a midpoint along the length of nanoribbons 104a). The first thickness of the portion of nanoribbons 104a that contacts first inner spacers 116 and/or source or drain regions 106 may be substantially equal to the thickness of second nanoribbons 104b. The second thickness of the portion of nanoribbons 104a within the gate trench (e.g., and away from transition region 120) may be, for instance, at least 2 nm, at least 3 nm, at least 4 nm, or at least 5 nm thinner compared to the first thickness of the portion of nanoribbons 104a that contacts first inner spacers 116 and/or source or drain regions 106.

Figure 1C provides a plan view of a portion of the integrated circuit taken across a given layer of nanoribbons 104a/104b. The cross-section of Figure 1A is taken across the 1A dashed line and the cross-section of Figure 1B is taken across the 1B dashed line. As shown is this example of Figure 1C, the pitch of the patterned gates does not change between first and second semiconductor devices 101 and 103, such that w₁ + w₂ is substantially equal to w₃ + w₄. In such an example, each of gate structures 110a and 110b of devices 101 and 103 has a substantially same width along the first direction and laterally between spacer structures 114 (e.g., all such thicknesses are within 10 angstroms of each other), but still have gate length diversity along the first direction down lower in the gate trench (e.g., w₁ and w₃ are 2 nm or more different from one another). The length of first and second gate structures 110a/110b (along the first direction) may be substantially the same in the regions between nanoribbons 104a/104b along the second direction. The length of the gate structures may then be controllably altered via the process described herein by changing the width of the inner spacers at nanoribbons 104a.

According to some embodiments, a dielectric fill 122 is present along the source/drain trench (e.g., extending along the second direction) between source or drain regions 106/108. Dielectric fill 122 may be present to isolate adjacent source or drain regions and may include any suitable dielectric material, such as silicon dioxide. In some embodiments, one or more gate cut structures 124 extend along the first direction between adjacent semiconductor devices to separate the gates of the adjacent semiconductor devices. Such gate cut structures 124 can further extend across any number of gate trenches and source/drain trenches to separate any number of devices. Gate cut structures 124 include any suitable dielectric material, such as silicon dioxide, silicon nitride, silicon oxynitride, silicon oxycarbide, or silicon oxycarbonitride. In the illustrated example, gate cut structure 124 separates first gate structure 110a from second gate structure 110b along the second direction.

### Fabrication Methodology

Figures 2A - 12A and 2B - 12B include cross-sectional views that collectively illustrate an example process for forming an integrated circuit having one or more first semiconductor devices with laterally thinner inner spacers and thinner nanoribbons compared to one or more second semiconductor devices, in accordance with an embodiment of the present disclosure. Figures 2A - 12A represent a similar cross-sectional view taken across a first set of semiconductor devices like those illustrated in Figure 1A, while Figures 2B - 12B represent a similar cross-sectional view taken across a second set of semiconductor devices like those illustrated in Figure 1B. Each set of figures sharing the same letter shows an example structure that results from the process flow up to that point in time, so the depicted structure evolves as the process flow continues, culminating in the structures shown in Figures 12A and 12B, which is similar to the structures shown in Figures 1A and 1B, respectively. Such structures may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. The process described herein in Figures 2-12 may be repeated any number of times for any number of semiconductor devices to form devices with different nanoribbons thickness and/or different inner spacer width.

Figures 2A and 2B each illustrates a cross-sectional view taken through substrate 102 having a series of material layers formed over the substrate, according to an embodiment of the present disclosure. Alternating material layers may be deposited over substrate 102 including sacrificial layers 202 alternating with semiconductor layers 204. The alternating layers are used to form GAA transistor structures. Any number of alternating sacrificial layers 202 and semiconductor layers 204 may be deposited over substrate 102. It should be noted that the cross-sections illustrated in Figures 2A and 2B may be taken along the length of a first fin 206 parallel to a second fin 208 that are each formed from the multiple layers and extending up above the surface of substrate 102. In other examples, first fin 206 and second fin 208 are different colinear sections of the same fin.

According to some embodiments, semiconductor layers 204 have a different material composition than sacrificial layers 202. In some embodiments, semiconductor layers 204 are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204 and in sacrificial layers 202, the germanium concentration is different between semiconductor layers 204 and sacrificial layers 202. For example, semiconductor layers 204 may include a higher germanium content compared to sacrificial layers 202. In some examples, sacrificial layers 202 may be doped with either n-type dopants (to produce a p-channel transistor) or p-type dopants (to produce an n-channel transistor). Note that a sacrificial layer 202 is provided as both the first and last layer of the layer stack on substrate 102.

While dimensions can vary from one example embodiment to the next, the thickness of each semiconductor layer 204 may be between about 5 nm and about 20 nm. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

Figures 3A and 3B depict the cross-section views of the structure shown in Figures 2A and 2B, respectively, following the formation of sacrificial gate structures 302 and spacer structures 304 over the alternating layer structure of the fins, according to an embodiment. Sacrificial gate structures 302 may run in an orthogonal direction (e.g., along a second direction) to the length of the fins and may include any material that can be safely removed later in the process without etching or otherwise damaging any portions of the fins or of spacer structures 304. In some embodiments, sacrificial gate structures 302 include polysilicon. Spacer structures 304 may be formed using an etch-back process where spacer material is deposited everywhere and then anisotropically etched to leave the material only on sidewalls of structures including sacrificial gate structures 302. Spacer structures 304 may include a dielectric material, such as silicon nitride, silicon oxynitride, or silicon oxycarbide. Sacrificial gate structures 302 together with spacer structures 304 define portions of the fin that will be used to form first and second semiconductor devices, as discussed further herein. Note that the pitch and width across the first direction of sacrificial gate structures 302 is substantially the same across the fins illustrated in both Figures 3A and 3B, according to some embodiments.

Figures 4A and 4B depict cross-section views of the structures shown in Figures 3A and 3B following the removal of exposed portions of the fins not protected by sacrificial gates 302 and spacer structures 304, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 302) along the first direction, according to some embodiments. In some embodiments, at least a portion of substrate 102 is also removed at the bottom of the recesses.

Figures 5A and 5B depict cross-section views of the structure shown in Figures 4A and 4B, respectively, following the removal of portions of sacrificial layers 202, according to an embodiment of the present disclosure. A selective and timed isotropic etching process may be used to recess the exposed ends of each sacrificial layers 202 of first fin 206 and second fin 208, thus yielding lateral cavities 502. The etch is selective to semiconductor layers 204 and gate spacers 304, so as to largely remove only sacrificial layers 202. The amount of recessing of sacrificial layers 202 dictates the width of the inner spacer structures that will be formed within lateral cavities 502. To this end, the dwell time of the recess etch can be set to provide a desired recess depth. In the illustrated example, sacrificial layers 202 have been recessed to a lateral depth that is substantially similar to a width of spacer structures 304 along the first direction. Note the example structure here is described in terms of nanoribbons and a gate-all-around architecture. However, the structure could also be described in terms of nanosheets and a forksheet architecture. In such a case, sacrificial layers 202 and semiconductor layers 204 extend laterally outward (out of page) from a dielectric spine, and sacrificial gates 302 would wrap around the other ends of those layers 202 and 204.

Figures 6A and 6B depict cross-section views of the structure shown in Figures 5A and 5B, respectively, following the formation of inner spacers 602 within lateral cavities 502, according to an embodiment of the present disclosure. Inner spacers 602 may have a material composition that is similar to or the exact same as spacer structures 304. Accordingly, inner spacers 602 may be any suitable dielectric material that exhibits high etch selectively to semiconductor materials such as silicon and/or silicon germanium. In some examples, spacer structures 304 include silicon oxycarbide and inner spacers 602 include silicon oxycarbonitride. Inner spacers 602 may be, for example, conformally deposited over the sides of the fin structure using a conformal deposition process like CVD or ALD and then etched back using an isotropic etching process to expose the ends of semiconductor layers 204. According to some embodiments, inner spacers 602 have a similar width (e.g., along the first direction) to spacer structures 304.

Figures 7A and 7B depict cross-section views of the structure shown in Figures 7A and 7B, respectively, following the formation of first source or drain regions 702a and second source or drain regions 702b within the source/drain trenches of the different devices, according to some embodiments. Source or drain regions 702a/702b may be formed in the areas that had been previously occupied by the exposed fins between spacer structures 304. According to some embodiments, source or drain regions 702a/702b are epitaxially grown from the exposed semiconductor material at the ends of semiconductor layers 204.

According to some embodiments, a dielectric fill 704 is provided over source or drain regions 702a/702b. In some examples, dielectric fill 704 occupies a remaining volume within the source/drain trenches around and over portions of source or drain regions 702a/702b. Dielectric fill 704 may be any suitable dielectric material, such as silicon dioxide. In some examples, dielectric fill 704 extends up to and planar with a top surface of spacer structures 304 (e.g., following a polishing procedure).

Figures 8A and 8B depict cross-section views of the structure shown in Figures 7A and 7B, respectively, following the removal of sacrificial gates 302 and sacrificial layers 202 from the devices of first fin 206, according to some embodiments. Second fin 208 may be protected using a mask structure 801. According to some embodiments, mask structure 801 is a suitable hard mark material, such as carbon hard mask (CHM). Mask structure 801 may be patterned using suitable lithography techniques to cover second fin 208 while not being present over first fin 206. In the illustrated example, mask structure 801 is formed after the removal of sacrificial gates 302 over both first fin 206 and second fin 208 but before the removal of sacrificial layers 202.

Once sacrificial gates 302 are removed, the fins extending between spacer structures 304 are exposed. According to some embodiments, sacrificial layers 202 of first fin 206 are selectively removed using a suitable isotropic etching process to leave behind first nanoribbons 802 that extend between corresponding source or drain regions 702a. Each vertical set of first nanoribbons 802 represents the semiconductor region (also called channel region) of a different semiconductor device. It should be understood that nanoribbons 802 may also be nanowires or nanosheets. Sacrificial gates 302 and sacrificial layers 202 may be removed using the same isotropic etching process or different isotropic etching processes.

Figures 9A and 9B depict cross-section views of the structure shown in Figures 8A and 8B, respectively, following one or more isotropic etching processes within the gate trenches across first fin 206, according to some embodiments. Such processes cause lateral etching of the exposed inner spacers to form thinned spacers 902 while also oxidizing exposed portions of first nanoribbons 802 within the gate trenches to form oxidized regions 904, according to some embodiments.

Thinned spacers 902 may have a width w₂ along the first direction that is, for example, at least 1 nm, at least 2 nm, or at least 3 nm less than the width of spacer structures 304 and/or the width w₄ of inner spacers 602 along the first direction. In some examples, thinned spacers 902 have a width w₂ between about 3 nm and about 5 nm.

According to some embodiments, oxidized regions 904 include an oxidized form of the semiconductor material of first nanoribbons 802 (e.g., silicon dioxide or germanium oxide). The unoxidized region of first nanoribbon 802 defines the semiconductor channel. Accordingly, the amount of oxidation effectively tunes the thickness of the semiconductor channel. In the illustrated example, oxidized regions 904 taper away at the edges of the gate trench and are not present along the length of first nanoribbons 802 between thinned spacers 902. First nanoribbons 802 may have a first thickness t₁ between thinned spacers 902 and/or contacting source or drain regions 702a and a second thickness t₂ within the gate trench away from the edges of the gate trench (e.g., at a midpoint of the gate trench along the first direction). The second thickness t₂ may be, for example, at least 1 nm, at least 2 nm, at least 3 nm, at least 4 nm, or at least 5 nm smaller than the first thickness t₁. In some examples, the first thickness t₁ of first nanoribbons 802 is substantially the same as the first thickness t₁ of semiconductor layers 204 in second fin 208. The second thickness t₂ may be at least 10%, at least 15%, at least 20%, at least 25%, at least 30%, or at least 35% thinner compared to first thickness t₁.

According to some embodiments, the oxidation process used to form oxidized regions 904 etches little to none of spacers 902. In such situations, spacers 902 may have a similar width (w₄) as spacers 602 while nanoribbons 802 have the second thickness t2 that is thinner compared to thickness t1 of semiconductor layers 204 in second fin 208.

Figures 10A and 10B depict cross-section views of the structure shown in Figures 9A and 9B, respectively, following masking the first fin 206 and removing sacrificial gates 302 and sacrificial layers 202 from the devices of second fin 208, according to some embodiments. Prior to removing mask structure 801 from over second fin 208, another mask structure 1001 is formed within the gate trenches of first fin 206 to protect first nanoribbons 802. Mask structure 1001 may include any number of dielectric layers. In some examples, mask structure 1001 includes a liner and a fill on the liner. The liner may include aluminum oxide formed directly on oxidized regions 904 of first nanoribbons 802, and the fill may include silicon dioxide or any another suitable dielectric material.

Following the formation of mask structure 1001 over first fin 206, mask structure 801 may be removed over second fin 208 using any suitable isotropic etching technique. According to some embodiments, sacrificial layers 202 of second fin 208 are selectively removed using a suitable isotropic etching process to leave behind second nanoribbons 1002 that extend between corresponding source or drain regions 702b. Each vertical set of second nanoribbons 1002 represents the semiconductor region (also called channel region) of a different semiconductor device. It should be understood that second nanoribbons 1002 may also be nanowires or nanosheets. Sacrificial gates 302 and sacrificial layers 202 may be removed using the same isotropic etching process or different isotropic etching processes.

Figures 11A and 11B depict cross-section views of the structure shown in Figures 10A and 10B, respectively, following the removal of mask structure 1001 and oxidized regions 904, according to some embodiments. Mask structure 1001 may be removed using any number of isotropic etching processes to remove each of the dielectric materials of the structure. Another isotropic etching process may be used to remove oxidized regions 904 thus yielding thinned sections of first nanoribbons 802 within the gate trenches across first fin 206.

Figures 12A and 12B depict cross-section views of the structure shown in Figures 11A and 11B, respectively, following the formation of gate structures 1202a and 1202b, according to some embodiments. Each of the gate structures 1202a/1202b includes a gate dielectric and a gate electrode on the gate dielectric. The gate dielectric may be first formed around nanoribbons 802/1002 prior to the formation of the gate electrode, which may include one or more conductive layers. The gate dielectric may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 802/1002, and a second layer on the first layer. The first layer can be, for instance, an oxide of the semiconductor material of nanoribbons 802/1002 (e.g., silicon dioxide) and the second layer can be a high-k dielectric material (e.g., hafnium oxide). The gate dielectric may be conformally deposited using CVD or ALD.

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates.

According to some embodiments, the gate lengths are different around first nanoribbons 802 compared to second nanoribbons 1002 due to the difference in the widths of thinned spacers 902 and inner spacers 602. Accordingly, the gate length w₁ of gate structures 1202a may be, for instance, at least 2 nm, at least 3 nm, or at least 4 nm greater than the gate length w₃ of gate structures 1202b, according to a few example embodiments. According to some such example embodiments, the gate length w₁ across first nanoribbons 802 may be, for instance, between about 15 nm and about 23 nm, such as between about 18 nm and about 19 nm, and the gate length w₃ across second nanoribbons 1002 may be, for instance, between about 11 nm and about 19 nm, such as between about 14 nm and about 15 nm.

Figure 13 illustrates an example embodiment of a chip package 1300, in accordance with an embodiment of the present disclosure. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and may provide, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via, or an interconnect structure that meanders through the thickness of substrate 1306 to contact one or more intermediate locations therein). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as wellas between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Methodology

Figure 14 is a flow chart of a method 1400 for forming at least a portion of an integrated circuit, according to an embodiment. Various operations of method 1400 may be illustrated in Figures 2A - 12A and 2B - 12B. However, the correlation of the various operations of method 1400 to the specific components illustrated in the aforementioned figures is not intended to imply any structural and/or use limitations. Rather, the aforementioned figures provide example embodiments of method 1400. Other operations may be performed before, during, or after any of the operations of method 1400. Some of the operations of method 1400 may be performed in a different order than the illustrated order.

Method 1400 begins with operation 1402 where first and second multilayer fins are formed having alternating semiconductor and sacrificial layers. The sacrificial layers may include SiGe while the semiconductor layers may be Si, SiGe, Ge, InP, or GaAs, to name a few examples. The thickness of each of the sacrificial and semiconductor layers may be, for instance, between about 5 nm and about 20 nm or between about 5 nm and about 10 nm. Each of the sacrificial and semiconductor layers may be deposited using any known material deposition technique, such as CVD, PECVD, PVD, or ALD. According to some embodiments, the multilayer fins include a sacrificial layer as a topmost layer and as a bottommost layer.

Method 1400 continues with operation 1404 where sacrificial gate and spacer structures are formed over the first and second fins, according to some embodiments. The sacrificial gates may be patterned using gate masking layers in strips that run orthogonally over the fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may include any suitable dielectric material, such as silicon nitride, silicon oxynitride, or silicon oxycarbide.

Method 1400 continues with operation 1406 where exposed portions of the fins are removed to form source/drain trenches. Any exposed portions of the fins not covered by the sacrificial gates or spacer structures may be removed using any anisotropic etching process, such as RIE.

Method 1400 continues with operation 1408 where the sacrificial layers of the first and second fins are laterally recessed to form recessed cavities. According to some embodiments, an isotropic etching process may be used to etch the exposed ends of the sacrificial layers while etching little to none of the semiconductor layers. The recessed cavities may have a lateral depth that is around the same width as the spacer structures (e.g., 5 nm - 7 nm).

According to some embodiments, the recessed cavities are filled with a dielectric material to form inner spacers. The inner spacers may have a material composition that is similar to or the exact same as the spacer structures. Accordingly, the inner spacers may be any suitable dielectric material that exhibits high etch selectively to semiconductor materials such as silicon and/or silicon germanium. In one example, the inner spacers include silicon oxycarbonitride. The inner spacers may be, for example, conformally deposited over the sides of the first and second fins using a conformal deposition process like CVD or ALD and then etched back using an isotropic etching process to expose the ends of the semiconductor layers, thus leaving the inner spacers within the recessed cavities.

Method 1400 continues with operation 1410 where source or drain regions are formed at opposite ends of the first and second fins on the semiconductor layers within the source/drain trenches. The source or drain regions may be formed in the areas that had been previously occupied by the exposed fins between the spacer structures. According to some embodiments, the source or drain regions are epitaxially grown from the semiconductor layers. In some example embodiments, the source or drain regions are NMOS source or drain regions (e.g., epitaxial silicon with n-type dopants) or PMOS source or drain regions (e.g., epitaxial SiGe with p-type dopants). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth or may include a gate cut structure separating them.

Method 1400 continues with operation 1412 where the sacrificial gate is removed over both the first and second fin. According to some embodiments, the sacrificial gate may be removed using any suitable isotropic etching process. The removal of the sacrificial gates exposes the multilayer first and second fins extending between the spacer structures within their corresponding gate trenches.

Method 1400 continues with operation 1414 where a mask structure is formed over the first fin and the sacrificial layers are removed from the second fin. The mask structure may be a suitable hard mark material, such as CHM. The mask structure may be patterned using suitable lithography techniques to cover the first fin while not being present over the second fin.

According to some embodiments, the sacrificial layers of the second fin are selectively removed using a suitable isotropic etching process to leave behind the semiconductor layers of the first fin as nanoribbons extending between corresponding source or drain regions.

Method 1400 continues with operation 1416 where the inner spacer structures adjacent to ends of the nanoribbons are laterally recessed. An isotropic etching process may be performed to etch back the inner spacers from within the gate trenches across the second fin. In some examples, the inner spacers have a different dielectric material composition compared to the gate spacers and thus may be etched at a substantially faster rate compared to the gate spacers depending on the etch chemistry. The inner spacers of the second fin may be thinned to have a final width along the first direction that is, for instance, at least 1 nm, at least 2 nm, or at least 3 nm less than the width along the first direction of the inner spacers of the first fin. In some examples, the thinned inner spacers of the second fin have a final width between about 3 nm and about 5 nm.

Method 1400 continues with operation 1418 where a portion of the nanoribbons within the gate trench is oxidized to form oxidized nanoribbon portions. According to some embodiments, the same etching process used to laterally etch the inner spacers in operation 1416 also causes the oxidation of portions of the nanoribbons within the gate trench. In some other examples, a separate oxidation process is performed to oxidize the exposed nanoribbons of the second fin.

According to some embodiments, the oxidation process used in operation 1418 causes little to no etching of the inner spacers. In such examples, operation 1416 may be skipped entirely such that no procedures are performed to laterally recess the inner spacers.

Method 1400 continues with operation 1420 where the oxidized portions of the nanoribbons are removed to yield thinner nanoribbon portions of the second fin within the gate trench compared to nanoribbon portions beyond the gate trench (e.g., between the inner spacers). An isotropic etching process may be performed to remove the oxidized portion of the nanoribbons. Note that portions of the nanoribbons between the inner spacers are not thinned as they are protected from the etch and/or oxidation process by the inner spacers. According to some embodiments, the thinned region of the nanoribbons in the second fin may have a thickness that is, for instance, at least 1 nm, at least 2 nm, at least 3 nm, at least 4 nm, or at least 5 nm thinner compared to the thickness of nanoribbons formed from the first fin or compared to nanoribbon portions of the second fin beyond the gate trench.

### Example System

FIG. 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment (e.g., a module including an integrated circuit on a substrate, the substrate having one or more first GAA devices having laterally thinner inner spacers and thinner nanoribbons compared to one or more second GAA devices, as variously provided herein). In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

The following examples pertain to further embodiments, from which numerous permutations and configurations will be apparent.

Example 1 is an integrated circuit having a first semiconductor device and a second semiconductor device. The first semiconductor device includes at least one first semiconductor body with a first thickness. The at least one first semiconductor body extends in a first direction from a first source or drain region. The first semiconductor device also includes a first gate structure extending in a second direction over the at least one first semiconductor body, and at least one first dielectric spacer between the first gate structure and the first source or drain region along the first direction. The second semiconductor device includes at least one second semiconductor body with a second thickness. The at least one second semiconductor body extends in the first direction from a second source or drain region. The second semiconductor device also includes a second gate structure extending in the second direction over the at least one second semiconductor body, and at least one second dielectric spacer between the second gate structure and the second source or drain region along the first direction. That least one first dielectric spacer is at least 1 nm wider than the at least one second dielectric spacer along the first direction. The first thickness of the at least one first semiconductor body is at least 2 nm greater than the second thickness of the at least one second semiconductor body.

Example 2 includes the integrated circuit of Example 1, wherein the at least one first semiconductor body and the at least one second semiconductor body comprise germanium, silicon, or a combination thereof.

Example 3 includes the integrated circuit of Example 1 or 2, wherein the at least one first semiconductor body and the at least one second semiconductor body are substantially coplanar on a plane extending in both the first and second directions.

Example 4 includes the integrated circuit of any one of Examples 1-3, wherein the at least one first dielectric spacer is over an end of the at least one first semiconductor body, and the at least one second dielectric spacer is over an end of the at least one second semiconductor body.

Example 5 includes the integrated circuit of any one of Examples 1-4, wherein the first gate structure has a first gate length over the at least one first semiconductor body along the first direction and the second gate structure has a second gate length over the at least one second semiconductor body along the first direction, the second gate length being at least 2 nm greater than the first gate length.

Example 6 includes the integrated circuit of any one of Examples 1-5, wherein the first semiconductor device further comprises a first gate spacer over the at least one first dielectric spacer and on a sidewall of the first gate structure, and the second semiconductor device further comprises a second gate spacer over the at least one second dielectric spacer and on a sidewall of the second gate structure.

Example 7 includes the integrated circuit of Example 6, wherein the first gate spacer and the second gate spacer have substantially the same width along the first direction.

Example 8 includes the integrated circuit of Example 6 or 7, wherein the first gate spacer and the at least one first dielectric spacer comprise substantially the same dielectric material, and the second gate spacer and the at least one second dielectric spacer comprise substantially the same dielectric material.

Example 9 includes the integrated circuit of Example 6 or 7, wherein the at least one first dielectric spacer and the at least one second dielectric spacer comprise nitrogen, and the first gate spacer and the second gate spacer do not comprise nitrogen.

Example 10 includes the integrated circuit of any one of Examples 1-9, wherein the at least one first semiconductor body has a first section along the first direction that contacts the first gate structure and a second section along the first direction and directly beneath the at least one first dielectric spacer, the first section having the first thickness and the second section having the second thickness.

Example 11 is a printed circuit board that includes the integrated circuit of any one of Examples 1-10.

Example 12 is an electronic device that includes a chip package having one or more dies. At least one of the one or more dies includes a plurality of first semiconductor nanoribbons extending in a first direction from a first source or drain region, a first gate structure extending in a second direction over the plurality of first semiconductor nanoribbons, at least one first dielectric spacer between the first gate structure and the first source or drain region, a plurality of second semiconductor nanoribbons extending in the first direction from a second source or drain region, a second gate structure extending in the second direction over the plurality of second semiconductor nanoribbons, and at least one second dielectric spacer between the second gate structure and the second source or drain region. The at least one first dielectric spacer is at least 1 nm wider than the at least one second dielectric spacer along the first direction. A first thickness of each of the plurality of first semiconductor nanoribbons is at least 2 nm greater than a second thickness of each of the plurality of second semiconductor nanoribbons.

Example 13 includes the electronic device of Example 12, wherein the plurality of first semiconductor nanoribbons and the plurality of second semiconductor nanoribbons comprise germanium, silicon, or a combination thereof.

Example 14 includes the electronic device of Example 12 or 13, wherein the plurality of first semiconductor nanoribbons and the plurality of second semiconductor nanoribbons are substantially coplanar on a plane extending in both the first and second directions.

Example 15 includes the electronic device of any one of Examples 12-14, wherein the at least one first dielectric spacer is over an end of at least one of the plurality of first semiconductor nanoribbons, and the at least one second dielectric spacer is over an end of at least one of the plurality of second semiconductor nanoribbons.

Example 16 includes the electronic device of any one of Examples 12-15, wherein the first gate structure has a first gate length over the plurality of first semiconductor nanoribbons along the first direction and the second gate structure has a second gate length over the plurality of second semiconductor nanoribbons along the first direction, the second length being at least 2 nm greater than the first length.

Example 17 includes the electronic device of any one of Examples 12-16, wherein the at least one of the one or more dies further comprises a first gate spacer over the at least one first dielectric spacer and on a sidewall of the first gate structure, and a second gate spacer over the at least one second dielectric spacer and on a sidewall of the second gate structure.

Example 18 includes the electronic device of Example 17, wherein the first gate spacer and the second gate spacer have substantially the same width along the first direction.

Example 19 includes the electronic device of Example 17 or 18, wherein the first gate spacer and the at least one first dielectric spacer comprise substantially the same dielectric material, and the second gate spacer and the at least one second dielectric spacer comprise substantially the same dielectric material.

Example 20 includes the electronic device of Example 17 or 18, wherein the at least one first dielectric spacer and the at least one second dielectric spacer comprise nitrogen, and the first gate spacer and the second gate spacer do not comprise nitrogen.

Example 21 includes the electronic device of any one of Examples 12-20, wherein at least one of the plurality of first semiconductor nanoribbons has a first section along the first direction that contacts the first gate structure and a second section along the first direction and directly beneath the at least one first dielectric spacer, the first section having the first thickness and the second section having the second thickness.

Example 22 includes the electronic device of any one of Examples 12-21, further comprising a printed circuit board, wherein the chip package is coupled to the printed circuit board.

Example 23 is a method of forming an integrated circuit. The method includes forming a first fin comprising first semiconductor layers alternating with first sacrificial layers, the first fin extending above a substrate and extending in a first direction; forming a second fin comprising second semiconductor layers alternating with second sacrificial layers, the second fin extending above a substrate and extending in the first direction; forming a first sacrificial gate and first spacer structures over the first fin and a second sacrificial gate and second spacer structures over the second fin; removing exposed portions of the first fin and the second fin not protected by the first sacrificial gate and first spacer structures and the second sacrificial gate and second spacer structures; laterally recessing the first sacrificial layers to form first laterally recessed areas and the second sacrificial layers to form second laterally recessed areas; forming first inner spacers within the first laterally recessed areas and second inner spacers within the second laterally recessed areas; forming a first source or drain region from exposed ends of the first semiconductor layers and a second source or drain region from exposed ends of the second semiconductor layers; removing the first and second sacrificial gates; forming a mask structure over the first fin; removing the second sacrificial layers of the second fin; performing a lateral etch of the second inner spacers around the second semiconductor layers; converting a portion of the second semiconductor layers into an oxidized portion; and removing the oxidized portion to yield thinner sections of the second semiconductor layers.

Example 24 includes the method of Example 23, wherein the converting the portion of the second semiconductor layers into the oxidized portion occurs during the lateral etch of the second inner spacers.

Example 25 includes the method of Example 23 or 24, further comprising removing the mask structure; removing the first sacrificial layers of the first fin; and forming a first gate structure over the first semiconductor layers and a second gate structure over the thinner sections of the second semiconductor layers.

Example 26 is an integrated circuit that includes a semiconductor device having at least one semiconductor nanoribbon extending in a first direction from a source or drain region and a gate structure extending in a second direction over the at least one semiconductor nanoribbon, a dielectric gate spacer on a sidewall of a top portion of the gate structure, and a dielectric inner spacer below the dielectric gate spacer and between the gate structure and the source or drain region along the first direction. The gate structure has a first length laterally adjacent to the dielectric gate spacer along the first direction and a second length laterally adjacent to the dielectric inner spacer along the first direction. The second length is at least 2 nm greater than the first length. The at least one semiconductor nanoribbon has a first section contacting the gate structure with a first thickness and a second section contacting the source or drain region with a second thickness. The second thickness is at least 2 nm greater than the first thickness.

Example 27 includes the integrated circuit of Example 26, wherein the at least one semiconductor nanoribbon comprises germanium, silicon, or a combination thereof.

Example 28 includes the integrated circuit of Example 26 or 27, wherein the dielectric inner spacer is over an end of the at least one semiconductor nanoribbon.

Example 29 includes the integrated circuit of any one of Examples 26-28, wherein the dielectric gate spacer has a third length along the first direction and the dielectric inner spacer has a fourth length along the first direction, the third length being at least 1 nm greater than the fourth length.

Example 30 includes the integrated circuit of any one of Examples 26-29, wherein the dielectric gate spacer and the dielectric inner spacer comprise substantially the same dielectric material.

Example 31 includes the integrated circuit of any one of Examples 26-29, wherein the dielectric inner spacer comprises nitrogen, and the dielectric gate spacer does not comprise nitrogen.

Example 32 includes the integrated circuit of any one of Examples 26-31, wherein the at second section of the at least one semiconductor nanoribbon is directly between and contacting the first section of the at least one semiconductor nanoribbon and the source or drain region along the first direction.

Example 33 includes the integrated circuit of any one of Examples 26-32, wherein the first thickness of the first section of the at least one semiconductor nanoribbon is between 3 nm and 5 nm.

Example 34 is a printed circuit board that includes the integrated circuit of any one of Examples 26-33.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

The following section of the description relates to further examples. The numbered paragraphs in this section are not claims. The claims are set forth below in the later section headed "claims".
1. An integrated circuit comprising:
   a first semiconductor device having at least one first semiconductor body with a first thickness, the at least one first semiconductor body extending in a first direction from a first source or drain region, a first gate structure extending in a second direction over the at least one first semiconductor body, and at least one first dielectric spacer between the first gate structure and the first source or drain region along the first direction; and
   a second semiconductor device having at least one second semiconductor body with a second thickness, the at least one second semiconductor body extending in the first direction from a second source or drain region, a second gate structure extending in the second direction over the at least one second semiconductor body, and at least one second dielectric spacer between the second gate structure and the second source or drain region along the first direction;
   wherein the at least one first dielectric spacer is at least 1 nm wider than the at least one second dielectric spacer along the first direction, and wherein the first thickness of the at least one first semiconductor body is at least 2 nm greater than the second thickness of the at least one second semiconductor body.
2. The integrated circuit of clause 1, wherein the at least one first semiconductor body and the at least one second semiconductor body are substantially coplanar on a plane extending in both the first and second directions.
3. The integrated circuit of clause 1, wherein the first gate structure has a first gate length over the at least one first semiconductor body along the first direction and the second gate structure has a second gate length over the at least one second semiconductor body along the first direction, the second gate length being at least 2 nm greater than the first gate length.
4. The integrated circuit of clause 1, wherein the first semiconductor device further comprises a first gate spacer over the at least one first dielectric spacer and on a sidewall of the first gate structure, and the second semiconductor device further comprises a second gate spacer over the at least one second dielectric spacer and on a sidewall of the second gate structure.
5. The integrated circuit of clause 4, wherein the first gate spacer and the second gate spacer have substantially the same width along the first direction.
6. The integrated circuit of clause 4, wherein the at least one first dielectric spacer and the at least one second dielectric spacer comprise nitrogen, and the first gate spacer and the second gate spacer do not comprise nitrogen.
7. The integrated circuit of clause 1, wherein the at least one first semiconductor body has a first section along the first direction that contacts the first gate structure and a second section along the first direction and directly beneath the at least one first dielectric spacer, the first section having the first thickness and the second section having the second thickness.
8. A printed circuit board comprising the integrated circuit of clause 1.
9. An electronic device, comprising:
   a chip package comprising one or more dies, at least one of the one or more dies comprising
   a plurality of first semiconductor nanoribbons extending in a first direction from a first source or drain region;
   a first gate structure extending in a second direction over the plurality of first semiconductor nanoribbons;
   at least one first dielectric spacer between the first gate structure and the first source or drain region;
   a plurality of second semiconductor nanoribbons extending in the first direction from a second source or drain region;
   a second gate structure extending in the second direction over the plurality of second semiconductor nanoribbons; and
   at least one second dielectric spacer between the second gate structure and the second source or drain region,
   wherein the at least one first dielectric spacer is at least 1 nm wider than the at least one second dielectric spacer along the first direction, and wherein a first thickness of each of the plurality of first semiconductor nanoribbons is at least 2 nm greater than a second thickness of each of the plurality of second semiconductor nanoribbons.
10. The electronic device of clause 9, wherein the plurality of first semiconductor nanoribbons and the plurality of second semiconductor nanoribbons are substantially coplanar on a plane extending in both the first and second directions.
11. The electronic device of clause 9, wherein the at least one first dielectric spacer is over an end of at least one of the plurality of first semiconductor nanoribbons, and the at least one second dielectric spacer is over an end of at least one of the plurality of second semiconductor nanoribbons.
12. The electronic device of clause 9, wherein the at least one of the one or more dies further comprises a first gate spacer over the at least one first dielectric spacer and on a sidewall of the first gate structure, and a second gate spacer over the at least one second dielectric spacer and on a sidewall of the second gate structure.
13. The electronic device of clause 12, wherein the first gate spacer and the second gate spacer have substantially the same width along the first direction.
14. The electronic device of clause 9, wherein at least one of the plurality of first semiconductor nanoribbons has a first section along the first direction that contacts the first gate structure and a second section along the first direction and directly beneath the at least one first dielectric spacer, the first section having the first thickness and the second section having the second thickness.
15. An integrated circuit comprising:
   a semiconductor device having at least one semiconductor nanoribbon, the at least one semiconductor nanoribbon extending in a first direction from a source or drain region, and a gate structure extending in a second direction over the at least one semiconductor nanoribbon;
   a dielectric gate spacer on a sidewall of a top portion of the gate structure; and
   a dielectric inner spacer below the dielectric gate spacer and between the gate structure and the source or drain region along the first direction,
   wherein the gate structure has a first length laterally adjacent to the dielectric gate spacer along the first direction, and a second length laterally adjacent to the dielectric inner spacer along the first direction, the second length being at least 2 nm greater than the first length, and
   wherein the at least one semiconductor nanoribbon has a first section contacting the gate structure with a first thickness and a second section contacting the source or drain region with a second thickness, the second thickness being at least 2 nm greater than the first thickness.
16. The integrated circuit of clause 15, wherein the dielectric inner spacer is over an end of the at least one semiconductor nanoribbon.
17. The integrated circuit of clause 15, wherein the dielectric gate spacer has a third length along the first direction and the dielectric inner spacer has a fourth length along the first direction, the third length being at least 1 nm greater than the fourth length.
18. The integrated circuit of clause 15, wherein the dielectric inner spacer comprises nitrogen, and the dielectric gate spacer does not comprise nitrogen.
19. The integrated circuit of clause 15, wherein the at second section of the at least one semiconductor nanoribbon is directly between and contacting the first section of the at least one semiconductor nanoribbon and the source or drain region along the first direction.
20. The integrated circuit of clause 15, wherein the first thickness of the first section of the at least one semiconductor nanoribbon is between 3 nm and 5 nm.

## Claims

1. An integrated circuit comprising:
a first semiconductor device having at least one first semiconductor body with a first thickness, the at least one first semiconductor body extending in a first direction from a first source or drain region, a first gate structure extending in a second direction over the at least one first semiconductor body, and at least one first dielectric spacer between the first gate structure and the first source or drain region along the first direction; and
a second semiconductor device having at least one second semiconductor body with a second thickness, the at least one second semiconductor body extending in the first direction from a second source or drain region, a second gate structure extending in the second direction over the at least one second semiconductor body, and at least one second dielectric spacer between the second gate structure and the second source or drain region along the first direction;
wherein the at least one first dielectric spacer is at least 1 nm wider than the at least one second dielectric spacer along the first direction, and wherein the first thickness of the at least one first semiconductor body is at least 2 nm greater than the second thickness of the at least one second semiconductor body.

2. The integrated circuit of claim 1, wherein the at least one first semiconductor body and the at least one second semiconductor body comprise germanium, silicon, or a combination thereof.

3. The integrated circuit of claim 1 or 2, wherein the at least one first semiconductor body and the at least one second semiconductor body are substantially coplanar on a plane extending in both the first and second directions.

4. The integrated circuit of any one of claims 1 through 3, wherein the at least one first dielectric spacer is over an end of the at least one first semiconductor body, and the at least one second dielectric spacer is over an end of the at least one second semiconductor body.

5. The integrated circuit of any one of claims 1 through 4, wherein the first gate structure has a first gate length over the at least one first semiconductor body along the first direction and the second gate structure has a second gate length over the at least one second semiconductor body along the first direction, the second gate length being at least 2 nm greater than the first gate length.

6. The integrated circuit of any one of claims 1 through 5, wherein the first semiconductor device further comprises a first gate spacer over the at least one first dielectric spacer and on a sidewall of the first gate structure, and the second semiconductor device further comprises a second gate spacer over the at least one second dielectric spacer and on a sidewall of the second gate structure.

7. The integrated circuit of claim 6, wherein the first gate spacer and the second gate spacer have substantially the same width along the first direction.

8. The integrated circuit of claim 6 or 7, wherein the first gate spacer and the at least one first dielectric spacer comprise substantially the same dielectric material, and the second gate spacer and the at least one second dielectric spacer comprise substantially the same dielectric material.

9. The integrated circuit of claim 6 or 7, wherein the at least one first dielectric spacer and the at least one second dielectric spacer comprise nitrogen, and the first gate spacer and the second gate spacer do not comprise nitrogen.

10. The integrated circuit of any one of claims 1 through 9, wherein the at least one first semiconductor body has a first section along the first direction that contacts the first gate structure and a second section along the first direction and directly beneath the at least one first dielectric spacer, the first section having the first thickness and the second section having the second thickness.

11. A printed circuit board comprising the integrated circuit of any one of claims 1 through 10.

12. A method of forming an integrated circuit, the method comprising:
forming a first fin comprising first semiconductor layers alternating with first sacrificial layers, the first fin extending above a substrate and extending in a first direction;
forming a second fin comprising second semiconductor layers alternating with second sacrificial layers, the second fin extending above a substrate and extending in the first direction;
forming a first sacrificial gate and first spacer structures over the first fin and a second sacrificial gate and second spacer structures over the second fin;
removing exposed portions of the first fin and the second fin not protected by the first sacrificial gate and first spacer structures and the second sacrificial gate and second spacer structures;
laterally recessing the first sacrificial layers to form first laterally recessed areas and the second sacrificial layers to form second laterally recessed areas;
forming first inner spacers within the first laterally recessed areas and second inner spacers within the second laterally recessed areas;
forming a first source or drain region from exposed ends of the first semiconductor layers and a second source or drain region from exposed ends of the second semiconductor layers;
removing the first and second sacrificial gates;
forming a mask structure over the first fin; removing the second sacrificial layers of the second fin;
performing a lateral etch of the second inner spacers around the second semiconductor layers;
converting a portion of the second semiconductor layers into an oxidized portion; and
removing the oxidized portion to yield thinner sections of the second semiconductor layers.

13. The method of claim 12, wherein the converting the portion of the second semiconductor layers into the oxidized portion occurs during the lateral etch of the second inner spacers.

14. The method of claim 12 or 13, further comprising:
removing the mask structure; and
removing the first sacrificial layers of the first fin.

15. The method of claim 14, further comprising:
forming a first gate structure over the first semiconductor layers and a second gate structure over the thinner sections of the second semiconductor layers.
